# EUROPEAN PATENT APPLICATION

(11) **EP 4 603 560 A1**
(43) Date of publication of application: **20.08.2025**
(21) Application number: 25157523.9
(22) Date of filing: 12.02.2025
(51) Int. Cl.: C09K 5/14, H01L 23/373, C09K 5/12

(54) **RHEOLOGY CONTROLLED METAL AMALGAMS BY INCLUDING NON-REFRACTORY FILLER PARTICLES**

(30) Priority: 13.02.2024 US 202463552982 P
(71) Applicant: Laird Technologies, Inc., Chesterfield, MO 63017 (US)
(72) Inventor: HODUL, John N., Chesterfield, Missouri, 63107 (US); WEMP, Claire K., Chesterfield, Missouri, 63017 (US); STRADER, Jason L., Chesterfield, Missouri, 63017 (US)
(74) Representative: Greif, Thomas

(57) **Abstract**

Disclosed are exemplary methods for rheologically controlling a metal amalgam by including non-refractory filler particles (*e.g.*, non-refractory metal filler particles, *etc.)* for processing and reliability enhancement as a thermal interface material. An exemplary method may comprise rheologically controlling a metal amalgam including filler particles (*e.g*., non-refractory metal filler particles, *etc.)* for use as a thermal interface material without sacrificing thermal conductivity and while maintaining rheology and spread control (*e.g*., limiting or preventing material migration, *etc.)* when pressed between two substrates. An exemplary method may comprise using non-refractory (not corrosive resistant) filler particles (*e.g.*, non-refractory metal filler particles, *etc.)* to achieve a stable homogenous metal amalgam suspension with viscosity control based on total filler particle loading without sacrificing thermal performance for thermal interface material applications. The rheology controlled metal amalgam may be used as a thermal interface material between a heat source and another component of an electronic device.

## Description

The entire disclosure this provisional patent application is incorporated herein by reference.

### FIELD

The present disclosure generally relates to rheologically controlling metal amalgams by including non-refractory filler particles (e.g., non-refractory filler particles, *etc.)* for processing and reliability enhancement as thermal interface materials (TIMs), *etc.*

### BACKGROUND

This section provides background information related to the present disclosure which is not necessarily prior art.

Electrical components, such as semiconductors, integrated circuit packages, transistors, *etc.*, typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated electronic device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material. The thermal interface material may be used to fill the gap between thermal transfer surfaces, in order to increase thermal transfer efficiency as compared to having the gap filled with air, which is a relatively poor thermal conductor.

### DRAWINGS

The drawings described herein are for illustrative purposes only of selected embodiments and not all possible implementations and are not intended to limit the scope of the present disclosure.

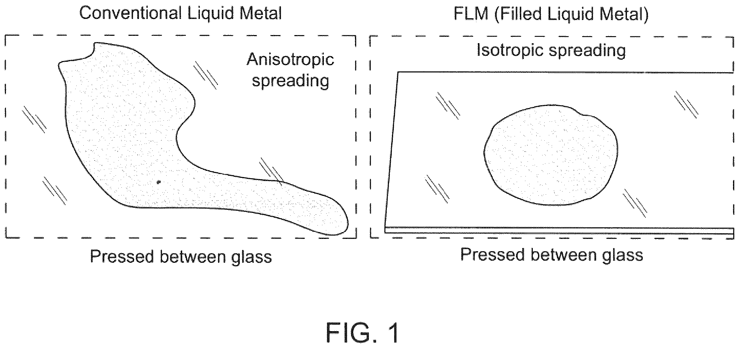

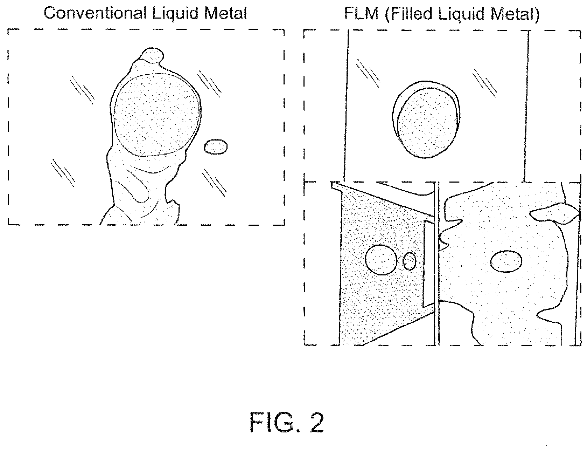

FIGS. 1 and 2 show comparisons between a conventional unfilled liquid metal without any nickel and copper filler and a filled liquid metal (FLM) according to exemplary embodiments disclosed herein. As compared to the conventional unfilled liquid metal without any nickel and copper filler, the filled liquid metal (FLM) after being filled or loaded with (*e.g.*, about 1 wt% to about 10 wt%, *etc.)* nickel and copper had enhanced or increased viscosity, comparable thermal performance, enhanced spread control (isotropic) *(e.g.,* limited, reduced, or no material migration, *etc.)* when pressed between two substrates or plates. As shown in FIG. 2, the filled liquid metal (FLM) did not bleed/pump out/creep out/migrate when thermal cycled, during thermal reliability testing, *e.g.,* vertical reliability test in thermal shock from -40 °C to 150 °C for 1000 cycles as shown in FIG. 2, *etc.* This offers a major benefit for processing liquid metal and having the material hold in place (*e*.*g*., without the material migrating, bleeding, pumping, or creeping out, *etc.)* during application performance in an electronic device.

### DETAILED DESCRIPTION

Example embodiments will now be described more fully with reference to the accompanying drawings.

As recognized herein, conventional rheology controlled liquid metal systems sacrifice thermal performance as the rheology and spreading properties are controlled. For example, conventional rheologically controlled materials include liquid metal containing silicone and/or polymer components, which limit the thermal conductivity and thermal resistance of the material. Conventional liquid metal spreads unevenly (anisotropic) when being pressed between two substrates or plates *(e.g.,* glass, *etc.)* as shown in FIG. 1, which causes problems in processing the material into devices for thermal interface material usage. Conventional liquid metal spreads (also known as creep, pump out, or movement) during thermal reliability testing as shown in FIG. 2.

After recognizing the above drawbacks with conventional rheology controlled liquid metal systems, exemplary embodiments were developed and/or are disclosed herein for controlling the rheology of metal amalgams (*e*.*g*., liquid metals, low melting alloys, gallium-based liquid metal alloys, *etc.)* by including, incorporating, or using non-refractory metal fillers *(e.g.,* nickel and copper, *etc.).* When adding non-refractory fillers (nickel and copper), the viscosity of the metal amalgam is increased without sacrificing the thermal performance of the metal amalgam. The metal fillers remain suspended in the metal amalgam.

In exemplary embodiments, a thermal interface material (TIM) includes non-refractory (not corrosive resistant) metal fillers incorporated into a metal amalgam *(e.g.,* liquid metal, low melting alloy, *etc.)* such that a stable metal amalgam suspension is obtained and with viscosity control based on the total loading of filler without sacrificing thermal performance for a TIM application. In such exemplary embodiments, metal amalgam will remain in place *(e.g.,* not migrate, bleed, pump out, or creep out, *etc.)* during thermal reliability testing, *e.g.,* vertical reliability test in thermal shock from -40 °C to 150 °C for 1000 cycles as shown in FIG. 2, *etc.* And the metal amalgam can be processed onto a substrate in a controlled manner due to the rheology control allowing for isotropic spreading of the material when pressed between two substrates or plates, as shown in FIG. 1, *etc.* The isotropic spread control *(e.g.,* limited, reduced, or no material migration, *etc.)* occurs when the TIM is pressed between two substrates or plates, which is a processing advantage in the TIM field as materials will be sandwiched in application and surface coverage of the TIM is important. Conventional liquid metal spreading anisotropic makes it difficult to process.

In exemplary embodiments, a metal alloy *(e.g.,* a low viscosity gallium-indium-tin liquid metal alloy, *etc.*) is filled with non-refractory metals copper and nickel particles, which allows for a stable homogeneous amalgam suspension resulting in an increase in viscosity, rheology control based on total loading of filler, robust wetting of various surfaces, and spreading control in processing and reliability. While these properties are enhanced, there is no sacrifice in the thermal performance of the material after the copper and nickel particles are mixed into the metal alloy. The appearance of the material may be a glossy, shiny, silver compound that has a custard-like consistency.

FIGS. 1 and 2 show comparisons between a conventional unfilled liquid metal without any nickel and copper filler and a filled liquid metal (FLM) according to exemplary embodiments disclosed herein. As compared to the conventional unfilled liquid metal without any nickel and copper filler, the filled liquid metal (FLM) after being filled or loaded with *(e.g.,* about 1 wt% to about 10 wt%, *etc.)* nickel and copper had enhanced or increased viscosity, comparable thermal performance, enhanced spread control (isotropic) *(e.g.,* limited, reduced, or no material migration, *etc.)* when pressed between two substrates or plates. As shown in FIG. 2, the filled liquid metal (FLM) did not bleed/pump out/creep out/migrate when thermal cycled, during thermal reliability testing, *e.g.,* vertical reliability test in thermal shock from -40 °C to 150 °C for 1000 cycles as shown in FIG. 2, *etc.* This offers a major benefit for processing liquid metal and having the material hold in place *(e.g.,* the material did not migrate, bleed, pump out, creep out, *etc.)* during application performance in an electronic device.

It was observed that a metal amalgam *(e.g.,* liquid metal, low melting alloy, gallium-indium-tin liquid metal alloy, *etc.*) after being filled or loaded with about 1 wt% to about 10 wt% *(e.g.,* about 6 wt%, *etc.)* of nickel and copper had enhanced or increased viscosity. For example, a low viscosity liquid consistency was observed for the conventional unfilled liquid metal alloy without any nickel and copper filler. By comparison, a custard-like consistency was observed for a metal amalgam including about 6 weight percent (wt%) of nickel and copper.

It was also observed that a metal amalgam *(e.g.,* liquid metal, low melting alloy, gallium-indium-tin liquid metal alloy, *etc.)* after being filled or loaded with about 1 wt% to about 10 wt% *(e.g.,* about 6 wt%, *etc.)* of nickel and copper had maintained a comparable thermal performance *(e.g.,* greater than 15 W/mK, *etc.)* as the conventional unfilled liquid metal alloy without any nickel and copper filler. For example, it was observed that a metal amalgam including about 6 weight percent (wt%) of nickel and copper had a thermal conductivity within a range from 28 W/mK to 30 W/mK.

As shown in FIG. 1, it was observed that a filled liquid metal after being filled or loaded with *(e.g.,* about 1 wt% to about 10 wt%, *etc.)* of nickel and copper had enhanced spread control (isotropic) *(e.g.,* limited, reduced, or no material migration, *etc.*) when pressed between two substrates or plates *(e.g.,* glass, *etc.).* By comparison, the conventional unfilled liquid metal without any nickel and copper filler spread unevenly (anisotropic) when pressed between two substrates or plates as also shown in FIG. 1.

As shown in FIG. 2, it was observed that the filled liquid metal after being filled or loaded with (*e*.*g*., about 1 wt% to about 10 wt%, *etc.*) of nickel and copper did not bleed/pump out/creep out/migrate when thermal cycled, *e.g.,* during a vertical reliability test in thermal shock from -40 °C to 150 °C for 1000 cycles, *etc.* By comparison, the conventional unfilled liquid metal without any nickel and copper filler did bleed/pump out/creep out/migrate when thermal cycled as also shown in FIG. 2.

In exemplary embodiments, a metal amalgam (*e*.*g*., liquid metal, low melting alloy, *etc.)* includes nickel and copper such that the ratio of the nickel to the copper by weight percent (wt%) is within a range from about 1:1 to about 5:1. For example, about a 2:1 nickel to copper ratio may be maintained in exemplary embodiments, which achieves a stable homogenous metal amalgam suspension. In exemplary embodiments, the metal amalgam is loaded or filled with the nickel and copper such that the total loading range of the nickel and copper is from about 1 wt% to about 10 wt% *(e.g.,* 4 wt%, 6 wt%, 8 wt%, *etc.).* In such exemplary embodiments, the filled metal amalgam may have a thermal conductivity greater than 15 W/mK *(e.g.,* 28 W/mK to 30 W/mK, *etc.*), a thermal resistance less than about 4 mm²K/W but not lower than about 1 mm²K/W, and a viscosity no greater than 2800 pascal-second at 0.5/s shear rate and no greater than 75 pascal-second at 5/s shear rate.

By way of example only, one exemplary embodiment of a filled metal amalgam comprises gallium-indium-tin liquid metal alloy filled or loaded with about 6 weight percent (wt%) of nickel and copper. In this example, the filled metal amalgam had a thermal conductivity within a range from about 28 W/mK to about 30 W/mK, a contact thermal resistance of less than about 4 mm²K/W, a viscosity (in air) strain rate 5/s within a range from about 28 to about 33 pascal-second, and a viscosity (in air) strain rate 0.5/s of about 407 pascal-second. From a consistency observational comparison, the filled metal amalgam had a custard-like appearance. The specific alloy, 6 wt% loading, thermal conductivity, thermal resistance, and viscosity provided in this paragraph and elsewhere are examples only as other exemplary embodiments may be configured differently, *e.g.,* different metal alloys *(e.g.,* another low melting alloy having a melting point of 160 °C or less, *etc.),* different liquid metal, higher or lower wt% loading, higher or lower thermal conductivity, higher or lower thermal resistance, and/or higher or lower viscosity, *etc.*

By way of another example only, another exemplary embodiment of a filled metal amalgam comprises gallium-indium-tin liquid metal alloy filled or loaded with about 8 weight percent (wt%) of nickel and copper. In this example, the filled metal amalgam had a thermal conductivity within a range from about 28 W/mK to about 30 W/mK, a contact thermal resistance of less than about 4 mm²K/W, a viscosity (in air) strain rate 5/s within a range from about 60 to about 65 pascal-second, and a viscosity (in air) strain rate 0.5/s of about 1997 pascal-second. From a consistency observational comparison, the filled metal amalgam had a consistency of a spreadable paste. The specific alloy, 8 wt% loading, thermal conductivity, thermal resistance, and viscosity provided in this paragraph and elsewhere are examples only as other exemplary embodiments may be configured differently, *e.g.,* different metal alloys *(e.g.,* another low melting alloy having a melting point of 160 °C or less, *etc.),* different liquid metal, higher or lower wt% loading, higher or lower thermal conductivity, higher or lower thermal resistance, and/or higher or lower viscosity, *etc.*

By way of further example only, a further exemplary embodiment of a filled metal amalgam comprises gallium-indium-tin liquid metal alloy filled or loaded with about 10 weight percent (wt%) of nickel and copper. In this example, the filled metal amalgam had a thermal conductivity within a range from about 28 W/mK to about 30 W/mK, a contact thermal resistance of less than about 4 mm²K/W, a viscosity (in air) strain rate 5/s within a range from about 60 to about 65 pascal-second, and a viscosity (in air) strain rate 0.5/s of about 2595 pascal-second. From a consistency observational comparison, the filled metal amalgam had a consistency of a spreadable thick paste. The specific alloy, 10 wt% loading, thermal conductivity, thermal resistance, and viscosity provided in this paragraph and elsewhere are examples only as other exemplary embodiments may be configured differently, e.g., different metal alloys *(e.g.,* another low melting alloy having a melting point of 160 °C or less, *etc.),* different liquid metal, higher or lower wt% loading, higher or lower thermal conductivity, higher or lower thermal resistance, and/or higher or lower viscosity, *etc.*

By comparison to the three examples above with 6, 8, and 10 wt% loadings of nickel and copper, a conventional unfilled liquid metal without any nickel and copper filler (0% filler loading wt%) may have a thermal conductivity within a range from about 28 W/mK to about 30 W/mK, a contact thermal resistance of less than about 4 mm²K/W, a viscosity (in air) strain rate 5/s within a range from about 13 to about 16 pascal-second, and a viscosity (in air) strain rate 0.5/s of about 180 pascal-second. From a consistency observational comparison, the conventional unfilled liquid metal without any nickel or copper filler had a consistency of a low viscosity liquid.

As shown by the above examples, the final consistency of the metal amalgam loaded with non-refractory filler particles is based on total loading of metal fillers. In exemplary embodiments, the ratio of the nickel to the copper by weight percent (wt%) is within a range from about 1:1 to about 5:1. For example, about a 2:1 nickel to copper ratio may be maintained in the filled metal amalgam, which achieves a stable homogenous metal amalgam suspension. Even though the consistency of the metal amalgam changes depending on the metal filler loading, the thermal performance remains the same, *e*.*g*., thermal conductivity greater than 15 W/mK *(e.g.,* within a range from about 28 W/mK to about 30 W/mK, *etc.)* and a thermal resistance of less than about 4 mm²K/W but not lower than about 1 mm²K/W.

The above examples show an example range of compositions in which enhanced effect was observed due to the presence of the non-refractory fillers (nickel and copper). These example compositions though observing an increased viscosity and enhanced spread control *(e.g.,* limited, reduced, or no material migration, *etc.)* when pressed between two substrates do not observe a change in thermal properties. This is a benefit in the field as other rheology controlled liquid metal included systems sacrifice thermal performance as the rheology and spreading properties are controlled.

Accordingly, exemplary embodiments disclosed herein may provide one or more (but not necessarily any or all) of the following advantages. For example, other conventional materials on the market that have rheology and spreading control with a liquid metal contain silicone and/or polymer components, which limit the thermal conductivity and thermal resistance of the material. By comparison, exemplary embodiments disclosed herein allow for no sacrifice in thermal conductivity and thermal resistance while still maintaining rheology and spreading control *(e.g.,* limiting or preventing material migration, *etc.).* Exemplary embodiments disclosed herein do not require any solder preform or surface treatments to keep the material in place and/or to wet the surface, as the metal amalgam *(e.g.,* liquid metal, low melting allow, *etc.*) loaded with non-refractory filler particles (*e*.*g*., non-refractory metal filler particles, *etc.)* therein is capable of wetting surfaces as is. Exemplary embodiments disclosed herein do not contain any organic solvents and/or compounds which could reduce wetting and/or lead to voiding from out-gassing during thermal cycling. For conventional filled liquid metal all metal amalgam systems, maintaining stable suspensions of particles in liquid metal is a key challenge. In exemplary embodiments disclosed herein, the metal amalgam remains a stable suspension after mixing particles into the metal amalgam (e.g., liquid metal, low melting alloy, *etc.*)*.* This stability is not traditionally achieved with non-refractory metals.

Disclosed are exemplary methods for rheologically controlling a metal amalgam by including non-refractory filler particles (e.g., non-refractory metal filler particles, *etc.)* for processing and reliability enhancement as a thermal interface material. An exemplary method may comprise rheologically controlling a metal amalgam including filler particles (e.g., non-refractory metal filler particles, *etc.*) for use as a thermal interface material without sacrificing thermal conductivity and while maintaining rheology and spread control (*e.g.*, limited, reduced, or no material migration, *etc.*) when pressed between two substrates. An exemplary method may comprise using non-refractory (not corrosive resistant) filler particles (*e*.*g*., non-refractory (not corrosive resistant) metal filler particles, *etc.)* to achieve a stable homogenous metal amalgam suspension with viscosity control based on total filler particle loading without sacrificing thermal performance for thermal interface material applications. The rheology controlled metal amalgam may be used as a thermal interface material between a heat source and another component of an electronic device.

In exemplary embodiments, the method includes rheologically controlling the metal amalgam including the non-refractory filler particles (e.g., non-refractory metal filler particles, *etc.*) to thereby allow processing of the metal amalgam including the non-refractory filler particles therein onto a substrate in a controlled manner due to the rheology control allowing for isotropic spreading of the liquid metal including the non-refractory filler particles therein when pressed between two substrates.

In exemplary embodiments, the method includes rheologically controlling the metal amalgam including the non-refractory filler particles (*e*.*g*., non-refractory metal filler particles, *etc.)* therein to thereby allow the metal amalgam to remain in place *(e.g.,* without the material migrating, bleeding, pumping or creeping out, *etc.)* during thermal reliability testing.

In exemplary embodiments, the method includes loading the non-refractory filler particles to thereby obtain a stable homogeneous metal amalgam suspension resulting in an increase in viscosity of the metal amalgam.

In exemplary embodiments, the method includes loading the non-refractory filler particles to thereby obtain rheology control based on total filler particle loading, robust wetting of various surfaces, and spreading control *(e.g.,* limiting or preventing material migration, *etc.*) in processing and reliability, and with no sacrifice in the thermal performance after the non-refractory filler particles are mixed into the metal amalgam.

In exemplary embodiments, the method includes loading low viscosity gallium-indium-tin liquid metal alloy with copper particles and nickel particles to thereby obtain a stable homogeneous metal amalgam suspension resulting in an increase in viscosity of the low viscosity gallium-indium-tin liquid metal alloy.

In exemplary embodiments, the method includes loading low viscosity gallium-indium-tin liquid metal alloy with copper particles and nickel particles to thereby obtain rheology control based on total metal filler particle loading, robust wetting of various surfaces, and spreading control *(e.g.,* limiting or preventing material migration, *etc.)* in processing and reliability, and with no sacrifice in the thermal performance after the copper particles and the nickel particles are mixed into the low viscosity gallium-indium-tin liquid metal alloy.

In exemplary embodiments, the method includes using the metal amalgam including the non-refractory filler particles therein as a thermal interface material without using or requiring any solder preform or surface treatments to keep the thermal interface material in place and/or to wet the surface.

In exemplary embodiments, the non-refractory filler particles comprise the non-refractory metal filler particle. And the method includes mixing the non-refractory metal filler particles into the metal amalgam to thereby provide an all metal amalgam system in which a stable suspension of the non-refractory metal filler particles is maintained in the metal amalgam.

In exemplary embodiments, the method includes dispensing or applying the metal amalgam including the non-refractory filler particles therein on a heat source, another component, or surface of an electronic device after rheologically controlling the metal amalgam including the non-refractory filler particles.

In exemplary embodiments, the method includes using the metal amalgam including the non-refractory filler particles therein to form a thermal joint between a heat source of an electronic device and another component of the electronic device.

Also disclosed are exemplary embodiments of thermal interface materials (TIMs) comprising metal amalgam including non-refractory filler particles *(e.g.,* non-refractory metal filler particles, *etc.).* The thermal interface materials is usable for establishing a thermal path for conducting heat from a heat source of an electronic device. Heat is flowable through the thermal path from the heat source during operation of the electronic device whereby temperature of the heat source is reduced.

In exemplary embodiments, the metal amalgam includes non-refractory filler particles *(e.g.,* non-refractory metal filler particles, *etc.)* that are rheologically controlled without sacrificing thermal conductivity and while maintaining rheology and spreading control *(e.g.,* limiting or preventing material migration, *etc.)* of the thermal interface material.

In exemplary embodiments, a stable homogenous metal amalgam suspension is achieved with viscosity control based on total filler particle loading without sacrificing thermal performance of the thermal interface material.

In exemplary embodiments, the metal amalgam including the non-refractory filler particles are rheologically controlled to thereby allow processing of the metal amalgam including the non-refractory filler particles therein onto a substrate in a controlled manner due to the rheology control allowing for isotropic even spreading of the metal amalgam including the non-refractory filler particles therein when pressed between two substrates.

In exemplary embodiments, the metal amalgam including the non-refractory filler particles are rheologically controlled to thereby allow the metal amalgam to remain in place *(e.g.,* not migrate, bleed, pump out, or creep out, *etc.)* during thermal reliability testing.

In exemplary embodiments, the metal amalgam is loaded with the non-refractory filler particles to thereby obtain a stable homogeneous metal amalgam suspension resulting in an increase in viscosity of the metal amalgam.

In exemplary embodiments, the metal amalgam is loaded with the non-refractory filler particles to thereby obtain rheology control based on total filler particle loading, robust wetting of various surfaces, and spreading control *(e.g.,* limiting or preventing material migration, *etc.)* in processing and reliability, and with no sacrifice in the thermal performance after the non-refractory filler particles are mixed into the metal amalgam.

In exemplary embodiments, the metal amalgam comprises a low melting alloy having melting point of 160 °C or less.

In exemplary embodiments, the non-refractory filler particles comprise copper and nickel. The metal amalgam is loaded with about 1 percent to about 10 percent of nickel and copper at a ratio of the nickel to the copper within a range from about 1:1 to about 5:1. And the metal amalgam including the nickel and copper therein has a thermal conductivity greater than 15 W/mK, a thermal resistance less than about 4 mm²K/W but not lower than about 1 mm²K/W, and a viscosity no greater than 2800 pascal-second at 0.5/s shear rate and no greater than 75 pascal-second at 5/s shear rate.

In exemplary embodiments, the metal amalgam comprises a gallium-based liquid metal (e.g., a low viscosity gallium-indium-tin liquid metal alloy, other low viscosity liquid metal, *etc.).* And the non-refractory filler particles comprise copper particles and nickel particles.

In exemplary embodiments, the thermal interface material comprises low viscosity gallium-indium-tin liquid metal alloy loaded with copper particles and nickel particles to thereby obtain a stable homogeneous metal amalgam suspension resulting in an increase in viscosity of the low viscosity gallium-indium-tin liquid metal alloy.

In exemplary embodiments, the thermal interface material comprises low viscosity gallium-indium-tin liquid metal alloy loaded with copper particles and nickel particles to thereby obtain rheology control based on total metal filler particle loading, robust wetting of various surfaces, and spreading control *(e.g.,* limiting or preventing material migration, *etc.)* in processing and reliability, and with no sacrifice in the thermal performance after the copper particles and the nickel particles are mixed into the low viscosity gallium-indium-tin liquid metal alloy.

In exemplary embodiments, the metal amalgam including the non-refractory filler particles therein do not contain any organic solvents and/or organic compounds, which could otherwise reduce wetting and/or lead to voiding from out-gassing during thermal cycling.

In exemplary embodiments, the metal amalgam including the non-refractory filler particles therein do not contain any silicone and/or any polymer components, which could otherwise reduce thermal conductivity.

In exemplary embodiments, the metal amalgam including the non-refractory filler particles therein consists of only metals.

In exemplary embodiments, the non-refractory filler particles comprise copper and nickel. And the metal amalgam includes a ratio of the nickel to the copper within a range from about 1:1 to about 5:1 by weight percent (wt%) and/or by volume percent (vol%).

In exemplary embodiments, the non-refractory filler particles comprise copper and nickel. And the metal amalgam is loaded with about 1 percent to about 10 percent of nickel and copper.

In exemplary embodiments, the non-refractory filler particles comprise copper and nickel. And the metal amalgam includes about a 2:1 ratio of the nickel to the copper by weight percent (wt%) and/or by volume percent (vol%).

In exemplary embodiments, the metal amalgam comprises a gallium-indium-tin liquid metal alloy. And the non-refractory filler particles comprise copper and nickel such that the gallium-indium-tin liquid metal alloy includes a ratio of the nickel to the copper within a range from about 1:1 to about 5:1 by weight percent (wt%) and/or by volume percent (vol%).

In exemplary embodiments, the non-refractory filler particles comprise copper and nickel. And the metal amalgam includes about 5 volume percent (vol%) of the nickel and about 2.5 volume percent (%vol) of the copper. In other exemplary embodiments, the metal amalgam is loaded with about 4 volume percent (vol%) of nickel and copper.

In exemplary embodiments, the thermal interface material comprising the metal amalgam including the non-refractory filler particles is usable for establishing a thermal path for conducting heat from a heat source of an electronic device without using or requiring any solder preform or surface treatments to keep the thermal interface material in place (e.g., without migration, bleeding, pump out, or creep out of the material, *etc.)* during thermal reliability testing and/or to wet the surface.

In exemplary embodiments, the non-refractory filler particles comprise non-refractory metal filler particles mixed into the metal amalgam to thereby provide an all metal amalgam system in which a stable suspension of the non-refractory metal filler particles is maintained in the metal amalgam.

In exemplary embodiments, the thermal interface material comprising the metal amalgam including the non-refractory filler particles is dispensable on the heat component or the another component of the electronic device.

In exemplary embodiments, an electronic device comprises a heat source, another component, and a thermal interface material as disclosed herein. The thermal interface material is positioned between the heat source and the another component to thereby establish the thermal path through which heat is flowable from the heat source during operation of the electronic device whereby temperature of the heat source is reduced,

Example embodiments are provided so that this disclosure will be thorough, and will fully convey the scope to those who are skilled in the art. Numerous specific details are set forth such as examples of specific components, electronic devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known electronic device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.*, the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that Parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if Parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. As used herein, the singular forms "a," "an," and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on," "engaged to," "connected to," or "coupled to" another element or layer, it may be directly on, engaged, connected or coupled to the other element or layer, or intervening elements or layers may be present. In contrast, when an element is referred to as being "directly on," "directly engaged to," "directly connected to," or "directly coupled to" another element or layer, there may be no intervening elements or layers present. Other words used to describe the relationship between elements should be interpreted in a like fashion (e.g., "between" versus "directly between," "adjacent" versus "directly adjacent," *etc.).* As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally," "about," and "substantially," may be used herein to mean within manufacturing tolerances. Or, for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about," the claims include equivalents to the quantities.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath," "below," "lower," "above," "upper" and the like, may be used herein for ease of description to describe one element or feature's relationship to another element(s) or feature(s) as illustrated in the figures. Spatially relative terms may be intended to encompass different orientations of the electronic device in use or operation in addition to the orientation depicted in the figures. For example, if the electronic device in the figures is turned over, elements described as "below" or "beneath" other elements or features would then be oriented "above" the other elements or features. Thus, the example term "below" can encompass both an orientation of above and below. The electronic device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A method for rheologically controlling a metal amalgam, the method comprising including non-refractory filler particles for processing and reliability enhancement of the metal amalgam for use as a thermal interface material without sacrificing thermal conductivity and while maintaining rheology and spread control and/or limiting or preventing material migration.

2. The method of claim 1, wherein:
the non-refractory filler particles comprise non-refractory (not corrosive resistant) metal filler particles; and
the method includes using the non-refractory (not corrosive resistant) metal filler particles to achieve a stable homogenous metal amalgam suspension with viscosity control based on total metal filler particle loading without sacrificing thermal performance for thermal interface material applications.

3. The method of any one of the preceding claims, wherein the method includes rheologically controlling the metal amalgam by including the non-refractory filler particles to thereby:
allow processing of the metal amalgam including the non-refractory filler particles therein onto a substrate in a controlled manner due to the rheology control allowing for isotropic spreading of the metal amalgam including the non-refractory filler particles therein when pressed between two substrates; and/or
allow the metal amalgam to remain in place with limited or no material migration during thermal reliability testing.

4. The method of any one of the preceding claims, wherein:
the non-refractory filler particles comprise non-refractory metal filler particles; and
the method includes loading the non-refractory metal filler particles to thereby provide one or more of
a stable homogeneous metal amalgam suspension resulting in an increase in viscosity of the metal amalgam;
rheology control based on total metal filler particle loading, robust wetting of various surfaces, limited or prevented material migration, and spreading control in processing and reliability, and with no sacrifice in the thermal performance after the non-refractory filler particles are mixed into the metal amalgam; and
an all metal amalgam system in which a stable suspension of the non-refractory metal filler particles is maintained in the metal amalgam.

5. The method of any one of the preceding claims, wherein:
the metal amalgam comprises a gallium-based liquid metal; and
the non-refractory filler particles comprise copper particles and nickel particles.

6. The method of claim 5, wherein:
the gallium-based liquid metal comprises a low viscosity gallium-indium-tin liquid metal alloy; and
the method includes loading the low viscosity gallium-indium-tin liquid metal alloy with the copper particles and the nickel particles to thereby provide:
a stable homogeneous metal amalgam suspension resulting in an increase in viscosity of the low viscosity gallium-indium-tin liquid metal alloy; and/or
rheology control based on total filler particle loading, robust wetting of various surfaces, limited or prevented material migration, and spreading control in processing and reliability, and with no sacrifice in the thermal performance after the copper particles and the nickel particles are mixed into the low viscosity gallium-indium-tin liquid metal alloy.

7. The method of any one of the preceding claims, wherein the non-refractory filler particles comprise copper and nickel, and wherein:
the metal amalgam is loaded with about 1 percent to about 10 percent of nickel and copper:
at a ratio of the nickel to the copper within a range from about 1:1 to about 5:1 by weight percent (wt%) and/or by volume percent (vol%); or
at a ratio of the nickel to the copper about a 2:1 ratio of the nickel to the copper by weight percent (wt%) and/or by volume percent (vol%); and/or
the metal amalgam including the nickel and copper therein has a thermal conductivity greater than 15 W/mK, a thermal resistance less than about 4 mm²K/W but not lower than about 1 mm²K/W, and a viscosity no greater than 2800 pascal-second at 0.5/s shear rate and no greater than 75 pascal-second at 5/s shear rate.

8. The method of any one of the preceding claims, wherein:
the metal amalgam including the non-refractory filler particles therein do not contain any organic solvents and/or organic compounds, which could otherwise reduce wetting and/or lead to voiding from out-gassing during thermal cycling; and/or
the metal amalgam including the non-refractory filler particles therein do not contain any silicone and/or any polymer components, which could otherwise reduce thermal conductivity; and/or
the metal amalgam including the non-refractory filler particles therein consists of only metals; and/or
the metal amalgam comprises a low melting alloy having melting point of 160 °C or less.

9. A thermal interface material comprising a metal amalgam including non-refractory filler particles for rheological control of the metal amalgam without sacrificing thermal conductivity and while maintaining rheology and spread control and/or limiting or preventing material migration.

10. The thermal interface of claim 9, wherein:
the non-refractory filler particles comprise non-refractory (not corrosive resistant) metal filler particles; and
the thermal interface material comprising the metal amalgam including the non-refractory (not corrosive resistant) metal filler particles is configured to achieve a stable homogenous metal amalgam suspension with viscosity control based on total metal filler particle loading without sacrificing thennal performance of the thermal interface material.

11. The thermal interface material of claim 9 or 10, wherein:
the non-refractory filler particles comprise non-refractory metal filler particles; and
the metal amalgam is loaded with the non-refractory metal filler particles to thereby provide one or more of:
a stable homogeneous metal amalgam suspension resulting in an increase in viscosity of the metal amalgam;
rheology control based on total metal filler particle loading, robust wetting of various surfaces, limited or prevented material migration, and spreading control in processing and reliability, and with no sacrifice in the thermal performance after the non-refractory filler particles are mixed into the metal amalgam; and
an all metal amalgam system in which a stable suspension of the non-refractory metal filler particles is maintained in the metal amalgam.

12. The thermal interface material of any one of claims 9 to 11, wherein:
the metal amalgam comprises a gallium-based liquid metal; and
the non-refractory filler particles comprise copper particles and nickel particles.

13. The thermal interface material of claim 12, wherein:
the gallium-based liquid metal comprises a low viscosity gallium-indium-tin liquid metal alloy; and
the low viscosity gallium-indium-tin liquid metal alloy is loaded with the copper particles and the nickel particles to thereby provide:
a stable homogeneous metal amalgam suspension resulting in an increase in viscosity of the low viscosity gallium-indium-tin liquid metal alloy; and/or
rheology control based on total filler particle loading, robust wetting of various surfaces, limited or prevented material migration, and spreading control in processing and reliability, and with no sacrifice in the thermal performance after the copper particles and the nickel particles are mixed into the low viscosity gallium-indium-tin liquid metal alloy.

14. The thermal interface material of any one of claims 9 to 13, wherein the non-refractory filler particles comprise copper and nickel, and wherein:
the metal amalgam is loaded with about 1 percent to about 10 percent of nickel and copper:
at a ratio of the nickel to the copper within a range from about 1:1 to about 5:1 by weight percent (wt%) and/or by volume percent (vol%); or
at a ratio of the nickel to the copper about a 2:1 ratio of the nickel to the copper by weight percent (wt%) and/or by volume percent (vol%); and/pr
the metal amalgam including the nickel and copper therein has a thermal conductivity greater than 15 W/mK, a thermal resistance less than about 4 mm²K/W but not lower than about 1 mm²K/W, and a viscosity no greater than 2800 pascal-second at 0.5/s shear rate and no greater than 75 pascal-second at 5/s shear rate.

15. The thermal interface material of any one of claims 9 to 14, wherein:
the metal amalgam including the non-refractory filler particles therein do not contain any organic solvents and/or organic compounds, which could otherwise reduce wetting and/or lead to voiding from out-gassing during thermal cycling; and/or
the metal amalgam including the non-refractory filler particles therein do not contain any silicone and/or any polymer components, which could otherwise reduce thermal conductivity; and/or
the metal amalgam including the non-refractory filler particles therein consists of only metals; and/or
the metal amalgam comprises a low melting alloy having melting point of 160 °C or less.
